# EUROPEAN PATENT APPLICATION

(11) **EP 4 773 790 A1**
(43) Date of publication of application: **08.07.2026**
(21) Application number: 25218214.2
(22) Date of filing: 25.11.2025
(51) Int. Cl.: H10N 60/80, H10N 60/81, H10N 69/00

(54) **QUANTUM DEVICE AND METHOD OF MANUFACTURING QUANTUM DEVICE**

(30) Priority: 07.01.2025 JP 2025002196
(71) Applicant: FUJITSU LIMITED, Kawasaki-shi, Kanagawa 211-8588 (JP)
(72) Inventor: KAWANO, Hiroyasu, Kawasaki-shi, 211-8588 (JP); FUKUMORI, Taiga, Kawasaki-shi, 211-8588 (JP)
(74) Representative: Haseltine Lake Kempner LLP

(57) **Abstract**

A quantum device (100) includes a quantum chip (10) including a substrate (11) having a first surface (12) and a second surface (13), a quantum bit (15) provided on the first surface, and an electrode (18) electrically connected to the quantum bit and provided on the second surface, a mounting portion (30) having a mounting surface (32) on which a peripheral edge portion of the quantum chip is mounted, the mounting portion having a linear expansion coefficient different from that of the substrate, a conductor pin (40) having a tip end in contact with the electrode, and a holding portion (50) fixed to the mounting portion, the holding portion holding the conductor pin and having a linear expansion coefficient different from that of the substrate, wherein the electrode has a shape having a longitudinal direction in a direction radially extending from a center of the substrate in plan view, and the quantum chip is mounted on the mounting surface by inserting a protrusion (31) provided on one of the substrate and the mounting surface into a hole (19) provided on another of the substrate and the mounting surface, the hole having a longitudinal direction in a direction extending radially in plan view.

## Description

### FIELD

A certain aspect of the present embodiments relates to a quantum device and a method of manufacturing a quantum device.

### BACKGROUND

A configuration in which a quantum chip is mounted on a substrate by solder is known (for example, U.S. Patent Application Publication No. 2020/0152540). In addition, a configuration in which two substrates are connected by solder is also known. In this case, in order to secure connection reliability, it is known that the planar shape of the pad to which a solder is connected is made elliptical (for example, Japanese Patent Application Publication No. 2015-153816, and Japanese Patent Application Publication No. 9-45733). Further, it is also known that a pad to which a lead terminal of a package component is solder-bonded has an elliptical planar shape (for example, Japanese Patent Application Publication No. 6-216299).

### SUMMARY

A quantum device is known which has a configuration in which a tip of a conductor pin is brought into contact with an electrode of a quantum chip having a quantum bit on a first surface of a substrate and an electrode electrically connected to the quantum bit on a second surface opposite to the first surface. In such a quantum device, after the tip of the conductor pin is brought into contact with the electrode under a first temperature environment, the quantum device is disposed under a second temperature environment lower than the first temperature in order to operate the quantum bit under a low temperature environment. When the quantum device is disposed in the second temperature environment, the tip of the conductor pin may be displaced from the electrode, and an electrical connection failure may occur.

According to one aspect, an object is to suppress the occurrence of the electrical connection failure.

According to an aspect of the present disclosure, there is provided a quantum device including: a quantum chip including a substrate having a first surface and a second surface, a quantum bit provided on the first surface, and an electrode electrically connected to the quantum bit and provided on the second surface; a mounting portion having a mounting surface on which a peripheral edge portion of the quantum chip is mounted, the mounting portion having a linear expansion coefficient different from that of the substrate; a conductor pin having a tip end in contact with the electrode; and a holding portion fixed to the mounting portion, the holding portion holding the conductor pin and having a linear expansion coefficient different from that of the substrate; wherein the electrode has a shape having a longitudinal direction in a direction radially extending from a center of the substrate in plan view, and the quantum chip is mounted on the mounting surface by inserting a protrusion provided on one of the substrate and the mounting surface into a hole provided on another of the substrate and the mounting surface, the hole having a longitudinal direction in a direction extending radially in plan view.

### BRIEF DESCRIPTION OF THE DRAWINGS

FIG. 1 is a cross-sectional view of a quantum device in accordance with a first embodiment.
FIG. 2 is a plan view of a substrate in the first embodiment.
FIG. 3A is a plan view of a quantum bit in the first embodiment.
FIG. 3B is a plan view of a Josephson junction element in the first embodiment.
FIG. 3C is a cross-sectional view taken along a line A-A in FIG. 3B.
FIGs. 4A to 4D are cross-sectional views illustrating a method of manufacturing the quantum device in accordance with the first embodiment (Part 1).
FIGs. 5A to 5D are cross-sectional views illustrating a method of manufacturing the quantum device in accordance with the first embodiment (Part 2).
FIGs. 6A and 6B are cross-sectional views illustrating a method of manufacturing the quantum device in accordance with the first embodiment (Part 3).
FIG. 7 is a cross-sectional view of a quantum device according to a comparative example.
FIG. 8 is a plan view of a substrate in the comparative example.
FIGs. 9A to 9C are plan views illustrating problems generated in the quantum device according to the comparative example.
FIGs. 10A to 10D are diagrams illustrating the effect of the quantum device in accordance with the first embodiment.
FIG. 11A is a plan view illustrating a substrate in a case where the number of quantum bits is increased in the first embodiment.
FIG. 11B is a cross-sectional view illustrating another example of the tip shape of a conductor pin in the first embodiment.
FIG. 12 is a cross-sectional view of a quantum device in accordance with a modification of the first embodiment.
FIG. 13 is a cross-sectional view of a quantum device in accordance with a second embodiment.
FIG. 14 is a plan view illustrating a mounting surface in the second embodiment.
FIGs. 15A to 15C are cross-sectional views illustrating a method of manufacturing the quantum device in accordance with the second embodiment (Part 1).
FIGs. 16A to 16C are cross-sectional views illustrating a method of manufacturing the quantum device in accordance with the second embodiment (Part 2).
FIGs. 17A and 17B are cross-sectional views illustrating a method of manufacturing the quantum device in accordance with the second embodiment (Part 3).
FIGs. 18A to 18D are diagrams illustrating the effect of the quantum device in accordance with the second embodiment.

### EFFECT

According to one aspect, it is possible to suppress the occurrence of the electrical connection failure.

### DESCRIPTION OF EMBODIMENTS

Hereinafter, embodiments of the present invention will be described with reference to the drawings.

### [First Embodiment]

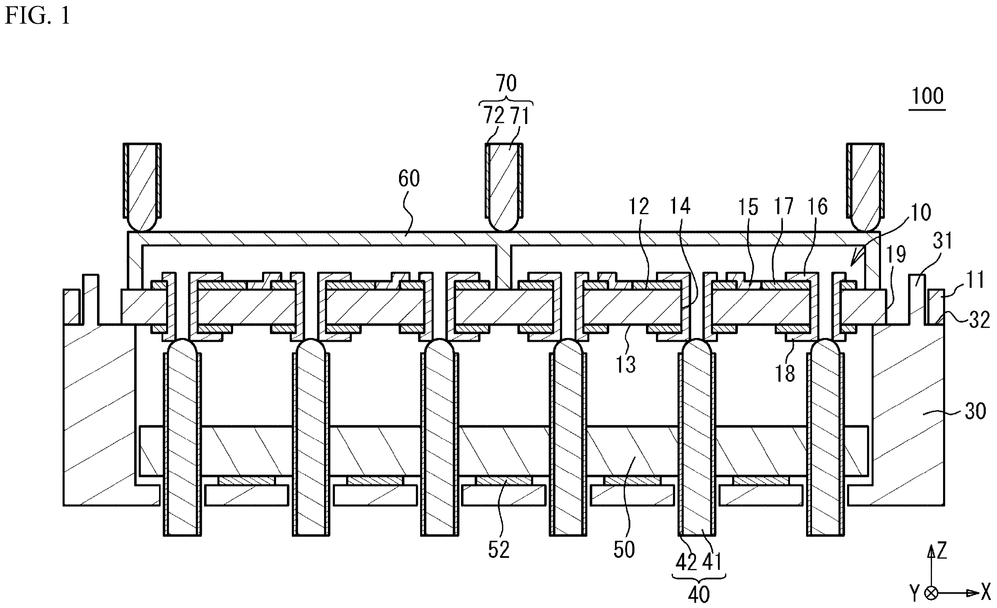

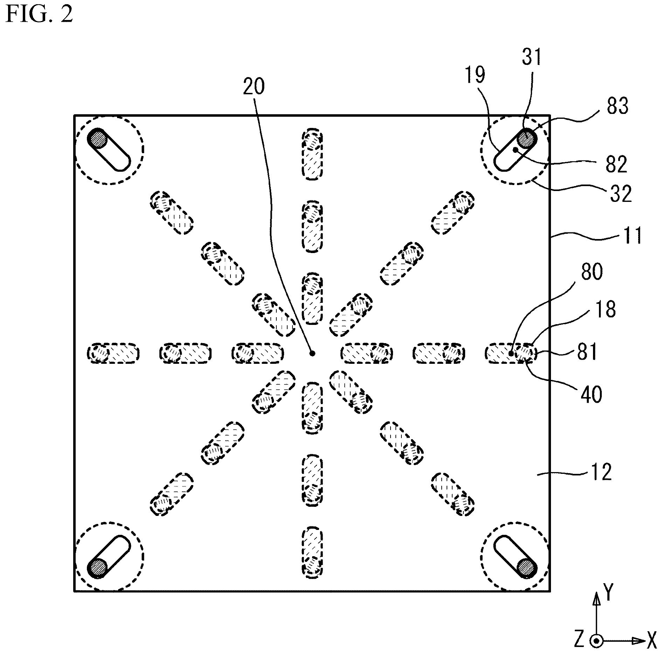

FIG. 1 is a cross-sectional view of a quantum device 100 in accordance with a first embodiment. FIG. 2 is a plan view of a substrate 11 in the first embodiment. FIGs. 1 and 2 illustrate a case where the quantum device 100 is placed in a normal temperature (for example, 5 °C to 35 °C) environment. In FIG. 2, electrodes 18, mounting surfaces 32, and conductor pins 40 are illustrated through the substrate 11. As illustrated in FIGs. 1 and 2, the quantum device 100 includes a quantum chip 10, a mounting portion 30, the conductor pins 40, a holding portion 50, a cover portion 60, and ground pins 70.

The quantum chip 10 includes the substrate 11 having a rectangular shape in a plan view, quantum bits 15 provided on an upper surface 12 of the substrate 11, and via wirings 16 provided on inner wall surfaces of holes 14 penetrating the substrate 11 from the upper surface 12 to a lower surface 13. The quantum chip 10 is disposed at a low temperature of, for example, several tens of milliKelvin (mK) and operates in a superconducting state. A superconducting film 17 connected to the quantum bits 15 is provided on the upper surface 12 of the substrate 11. The via wirings 16 are connected to the superconducting film 17 on the upper surface 12, and are electrically connected to the quantum bits 15 through the superconducting film 17. The via wirings 16 on the lower surface 13 serve as the electrodes 18 with which the tips of the conductor pins 40 come into contact. The via wirings 16 and the superconducting film 17 are formed of a superconducting material that exhibits superconductivity at a temperature equal to or lower than a predetermined temperature (for example, 10K). For example, the via wirings 16 are formed of aluminum, and the superconducting film 17 is formed of niobium or titanium nitride.

The tips of the conductor pins 40 are in contact with the electrodes 18. The conductor pin 40 includes a conductive portion 41 and an insulating coating portion 42 that coats the conductive portion 41. The conductive portion 41 is formed of a superconducting material, for example, aluminum. The coating portion 42 is formed of an insulating material, and is formed of, for example, silicon oxide. The tip of the conductive portion 41 is in contact with the electrode 18, so that the conductor pin 40 is electrically connected to the quantum bit 15 through the via wiring 16 and the superconducting film 17. The conductor pin 40 includes a control pin electrically connected to the quantum bit 15 to control the quantum bit 15 from the outside and/or a read pin electrically connected to the quantum bit 15 to extract a bit signal indicating the state of the quantum bit 15 to the outside.

The via wiring 16, the superconducting film 17, and the conductive portion 41 may be formed to contain at least one of niobium, vanadium, tantalum, aluminum, titanium, zinc, gallium, zirconium, molybdenum, tellurium, indium, tin, hafnium, germanium, antimony, yttrium, ruthenium, silicon, and titanium nitride.

The conductor pin 40 is held by the holding portion 50. The holding portion 50 is fixed to the mounting portion 30 having mounting surfaces 32 on which the peripheral edge portion of the quantum chip 10 is mounted. For example, the holding portion 50 is fixed to the mounting portion 30 via an elastic body portions 52 such as springs. Accordingly, the mounting portion 30 and the holding portion 50 are suppressed from rotating relative to each other, but can thermally contract and expand separately from each other. The mounting surfaces 32 are provided at positions corresponding to four corner portions of the substrate 11. The mounting surface 32 may be provided in a rectangular annular shape in plan view along the peripheral edge portion of the substrate 11. The mounting surface 32 is provided with a protrusion 31. The substrate 11 has holes 19 penetrating from the upper surface 12 to the lower surface 13 at four corners in plan view. The quantum chip 10 is mounted on the mounting surfaces 32 by inserting the protrusions 31 of the mounting surfaces 32 into the holes 19 of the substrate 11. The protrusion 31 may extend through the hole 19 and protrude from the upper surface 12 of the substrate 11.

Each of the electrode 18 and the hole 19 has an elongated shape having a longitudinal direction in a direction radially extending from a center 20 of the substrate 11 in plan view. The electrode 18 and the hole 19 have, for example, an oval shape in plan view, but may have an elliptical shape, a rectangular shape, or the like.

The holding portion 50 and the mounting portion 30 have a linear expansion coefficient different from that of the substrate 11. For example, the substrate 11 is formed of an insulating material such as silicon, the holding portion 50 is formed of a metal material such as aluminum, and the mounting portion 30 is formed of an insulating material such as ceramics such as alumina or glass. The linear expansion coefficient of silicon is about 4 × 10⁻⁶ /K, the linear expansion coefficient of aluminum is about 24 × 10⁻⁶ /K, the linear expansion coefficient of alumina is about 8 × 10⁻⁶ /K, and the linear expansion coefficient of glass is about 9 × 10⁻⁶ /K. Therefore, when the substrate 11 is formed of silicon and the holding portion 50 is formed of aluminum, the holding portion 50 has a larger linear expansion coefficient than that of the substrate 11. When the mounting portion 30 is formed of ceramics or glass, the mounting portion 30 has a larger linear expansion coefficient than the substrate 11. That is, the linear expansion coefficient of both the holding portion 50 and the mounting portion 30 is larger than that of the substrate 11.

The cover portion 60 that covers the quantum bit 15, the via wiring 16, and the superconducting film 17 is disposed on the substrate 11. The cover portion 60 is pressed against the substrate 11 by the ground pin 70 connected to the ground. The cover portion 60 is formed of a superconducting material such as aluminum. Similarly to the conductor pin 40, the ground pin 70 includes a conductive portion 71 formed of a superconducting material such as aluminum, and a coating portion 72 formed of an insulating material such as silicon oxide and coating the conductive portion 71. The cover portion 60 exhibits an electromagnetic shielding effect by being applied with a ground potential by the ground pin 70. The cover portion 60 and the conductive portion 71 of the ground pin 70 may be formed to include the materials exemplified for the via wiring 16, the superconducting film 17, and the conductive portion 41 of the conductor pin 40.

The conductor pin 40 is in contact with the electrode 18, for example, between a center 80 of the electrode 18 and an end 81 of the electrode 18 on the opposite side of the center 20 of the substrate 11 in plan view under a normal temperature environment. The protrusion 31 is inserted into the hole 19, for example, between a center 82 of the hole 19 and an end 83 of the hole 19 on the opposite side of the center 20 of the substrate 11 in plan view under the normal temperature environment.

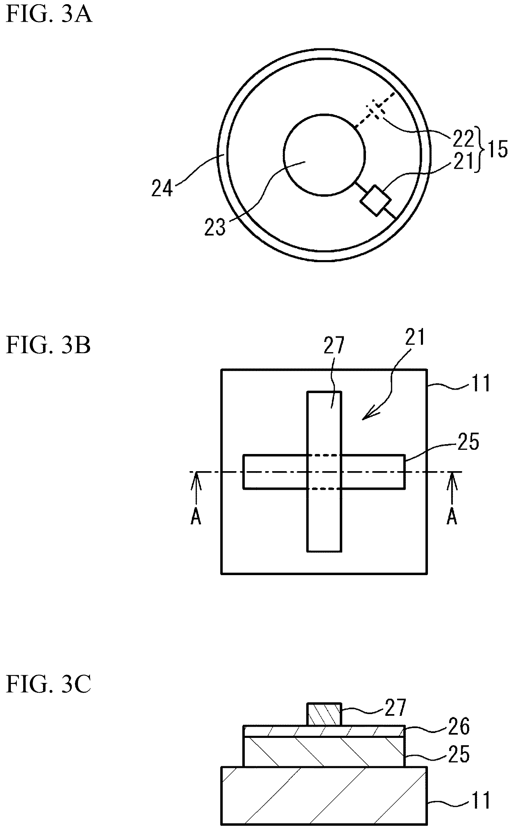

FIG. 3A is a plan view of the quantum bit 15 in the first embodiment. As illustrated in FIG. 3A, the quantum bit 15 includes a Josephson junction element 21 connected between a central electrode 23 and an outer peripheral electrode 24, and a capacitor 22 formed by the central electrode 23 and the outer peripheral electrode 24 facing each other. That is, the quantum bit 15 includes a transmon quantum bit circuit in which the Josephson junction element 21 and the capacitor 22 are connected in parallel. The quantum bit 15 is an element that forms a coherent two level system using superconductivity. The central electrode 23 and the outer peripheral electrode 24 are formed of, for example, the superconducting film 17.

FIG. 3B is a plan view of the Josephson junction element 21 in the first embodiment, and FIG. 3C is a cross-sectional view taken along a line A-A in FIG. 3B. In FIG. 3B, the insulating film 26 is not illustrated. As illustrated in FIGs. 3B and 3C, the Josephson junction element 21 includes a lower electrode 25 and an upper electrode 27, each of which is formed of a superconducting material, and an insulating film 26 formed of an insulating material and interposed between the lower electrode 25 and the upper electrode 27. The lower electrode 25 and the upper electrode 27 are provided so as to intersect each other. The lower electrode 25 and the upper electrode 27 are formed of, for example, aluminum, and the insulating film 26 is formed of, for example, aluminum oxide.

The quantum bit 15 is not limited to the transmon quantum bit circuit including the Josephson junction element 21, and may be other cases.

### [Manufacturing Method]

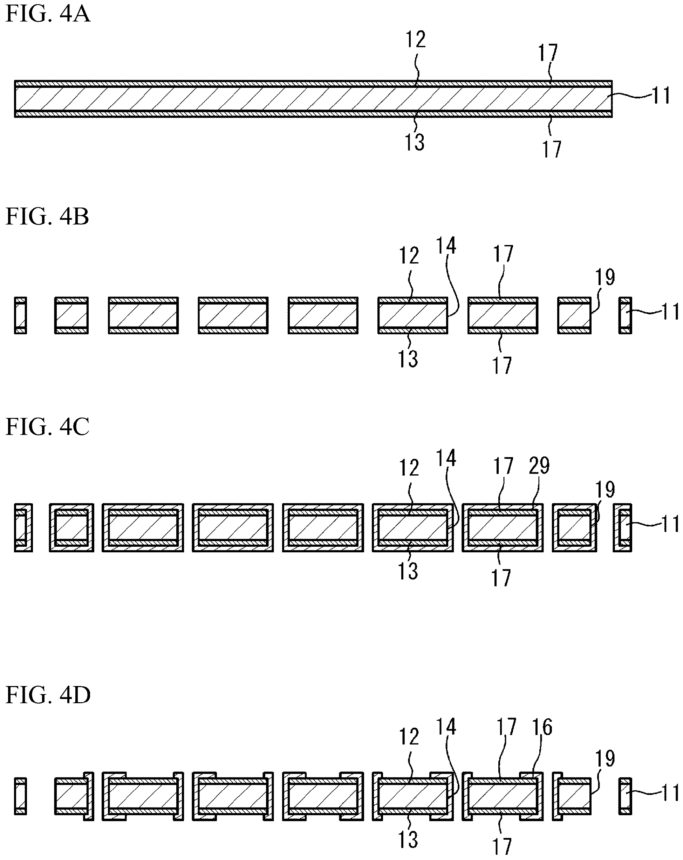

FIGs. 4A to 6B are cross-sectional views illustrating a method of manufacturing the quantum device 100 in accordance with the first embodiment. As illustrated in FIG. 4A, the superconducting film 17 made of, for example, niobium or titanium nitride is formed on the upper surface 12 and the lower surface 13 of the substrate 11 which is, for example, a silicon substrate. The superconducting film 17 is formed by using, for example, a sputtering method, a chemical vapor deposition (CVD) method, or an ion plating method. The thickness of the substrate 11 is, for example, about 300 µm to 1000 µm. The thickness of the superconducting film 17 is, for example, about 100 nm.

As illustrated in FIG. 4B, the superconducting film 17 and the substrate 11 are etched using a resist pattern (not illustrated) formed on the upper surface 12 and the lower surface 13 of the substrate 11 by a photolithography method as a mask. As a result, the holes 14 and the holes 19 are formed in the substrate 11 so as to penetrate the substrate 11 from the upper surface 12 to the lower surface 13. Thereafter, the resist pattern is removed. The holes 14 and the holes 19 are formed by a reactive ion etching method such as deep-reactive ion etching (Deep-RIE) using Bosch process, for example.

As illustrated in FIG. 4C, a superconducting film 29 is formed on the upper surface 12 and the lower surface 13 of the substrate 11 by using, for example, a sputtering method or a vacuum deposition method. The superconducting film 29 is also formed on the inner wall surfaces of the holes 14 and 19. The superconducting film 29 is, for example, an aluminum film. The thickness of the superconducting film 29 is, for example, about 300 nm.

As illustrated in FIG. 4D, the superconducting film 29 is patterned by etching using a resist pattern (not illustrated) formed on the upper surface 12 and the lower surface 13 of the substrate 11 by the photolithography method as a mask. The etching of the superconducting film 29 is performed by, for example, dry etching. Thereafter, the resist pattern is removed. As a result, the via wiring 16 extending from the upper surface 12 of the substrate 11 to the lower surface 13 through the hole 14 is formed.

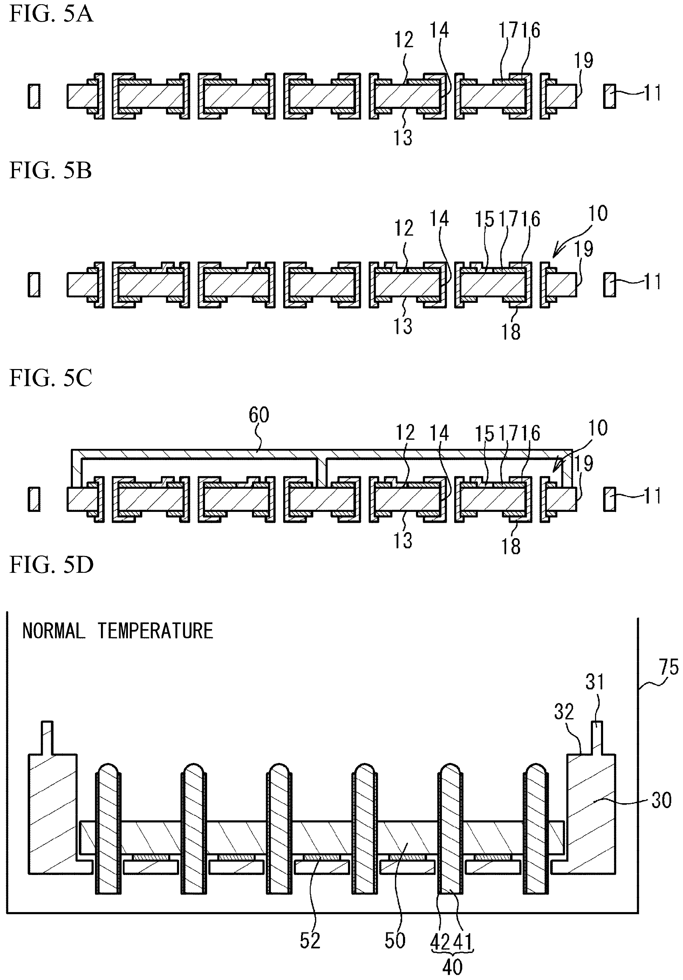

As illustrated in FIG. 5A, the superconducting film 17 is patterned by etching using a resist pattern (not illustrated) formed on the upper surface 12 and the lower surface 13 of the substrate 11 by the photolithography method as a mask. Thereafter, the resist pattern is removed. The etching of the superconducting film 17 is performed by, for example, dry etching.

As illustrated in FIG. 5B, the quantum bit 15 connected to the superconducting film 17 is formed on the upper surface 12 of the substrate 11. The quantum bit 15 is formed by using, for example, a lift-off method. The lower electrode 25 and the upper electrode 27 of the quantum bit 15 are formed by using, for example, an oblique vacuum deposition method. The insulating film 26 is formed by oxidizing the surface of the lower electrode 25. The quantum chip 10 is formed as described above.

As illustrated in FIG. 5C, the cover portion 60 is disposed on the upper surface 12 of the substrate 11. The cover portion 60 is not bonded to the upper surface 12 of the substrate 11.

As illustrated in FIG. 5D, the mounting portion 30 having the mounting surface 32 and the protrusion 31 provided on the mounting surface 32, and the holding portion 50 fixed to the mounting portion 30 via the elastic body portion 52 and holding the conductor pin 40 are disposed in a refrigerator 75. The protrusion 31 is formed by etching the mounting surface 32, for example. At this stage, the inside of the refrigerator 75 is not cooled and is at a normal temperature.

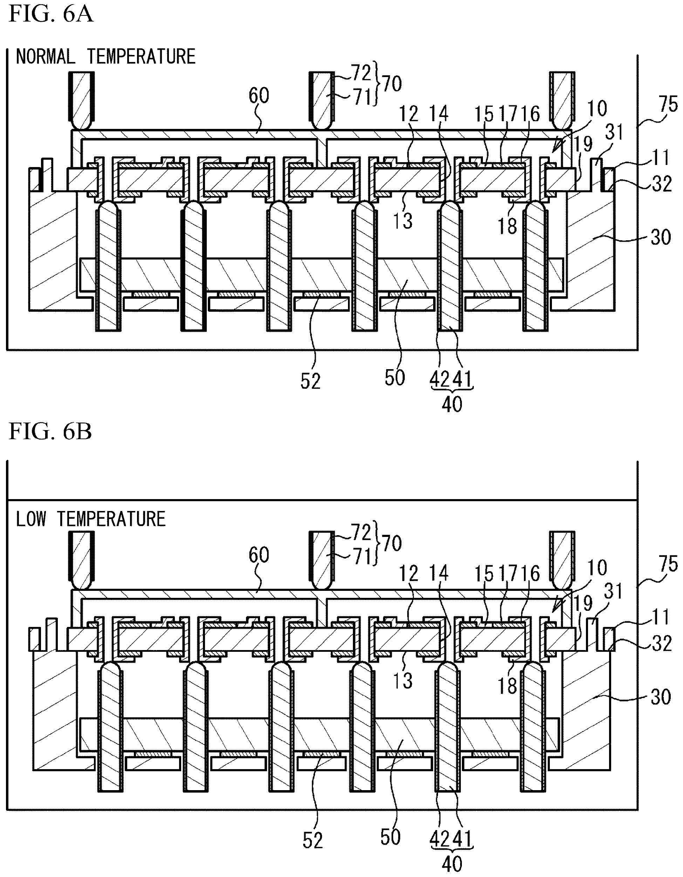

As illustrated in FIG. 6A, the protrusions 31 of the mounting surface 32 are inserted into the holes 19 of the substrate 11 under the normal temperature environment, and the peripheral edge portion of the quantum chip 10 is mounted on the mounting surface 32. As a result, the tip of the conductor pin 40 comes into contact with the electrode 18 provided on the lower surface 13 of the substrate 11. The ground pin 70 is pressed against the upper surface of the cover portion 60, and the cover portion 60 is pressed against the substrate 11.

As illustrated in FIG. 6B, the inside of the refrigerator 75 is exhausted, and the temperature inside the refrigerator 75 is cooled to a low temperature (for example, several tens of mK or less) at which the lower electrode 25 and the upper electrode 27 of the quantum bit 15 exhibit superconductivity. Thus, the quantum chip 10 operates in the superconducting state.

### [Comparative Example]

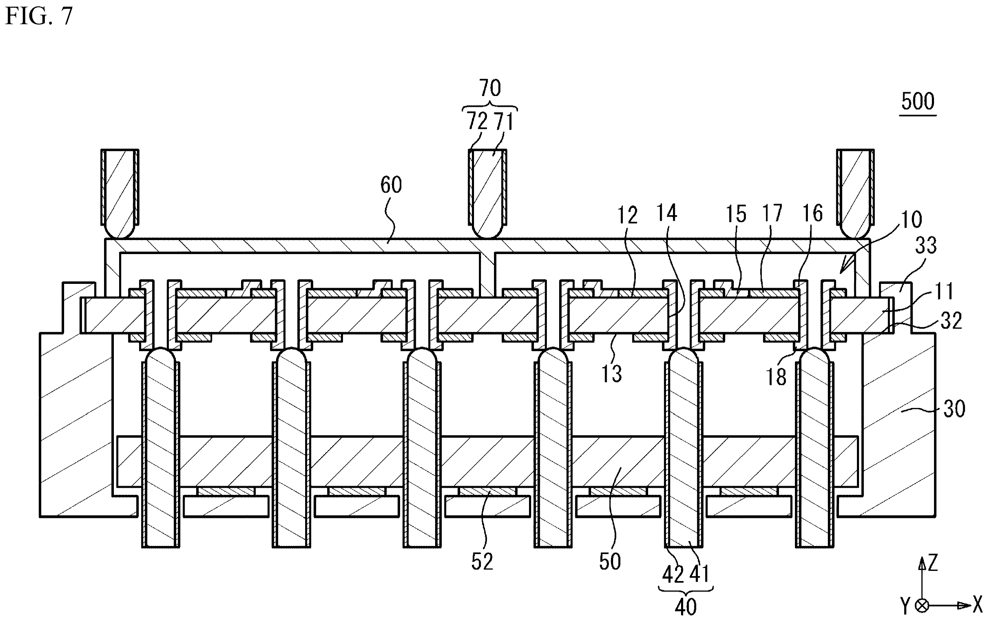

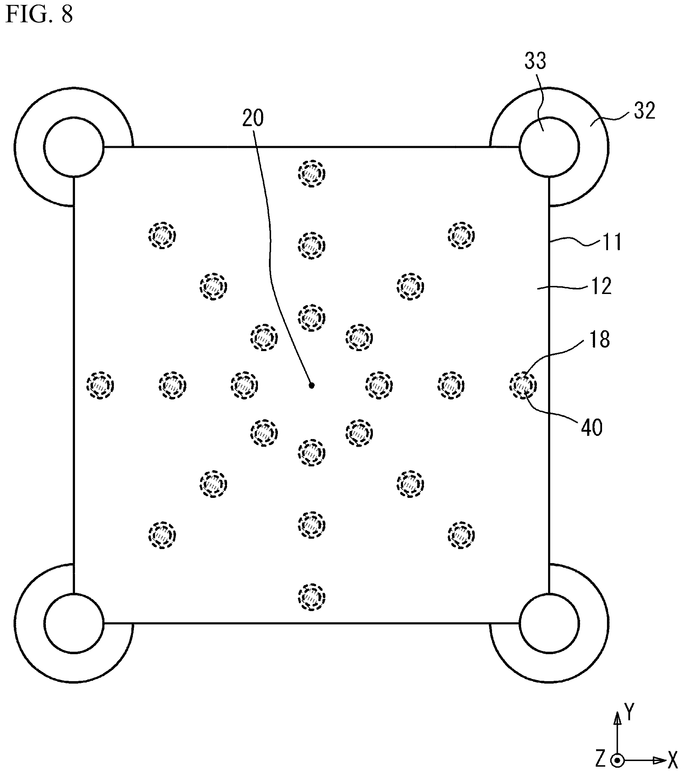

FIG. 7 is a cross-sectional view of a quantum device 500 according to a comparative example. FIG. 8 is a plan view of the substrate 11 in the comparative example. FIGs. 7 and 8 illustrate a case where the quantum device 500 is placed in the normal temperature environment. In FIG. 8, the electrodes 18 and the conductor pins 40 are illustrated through the substrate 11. As illustrated in FIGs. 7 and 8, in the comparative example, no hole is provided at the corners of the substrate 11. Protrusions 33 provided on the mounting surfaces 32 are provided so as to cover the corner portions of the substrate 11 to the upper surface 12. The electrode 18 provided on the lower surface 13 of the substrate 11 has a circular shape in plan view. The conductor pin 40 is in contact with the electrode 18 near the center thereof. The other configurations are the same as those of the first embodiment, and thus the description thereof will be omitted.

### [Problem Generated in Comparative Example]

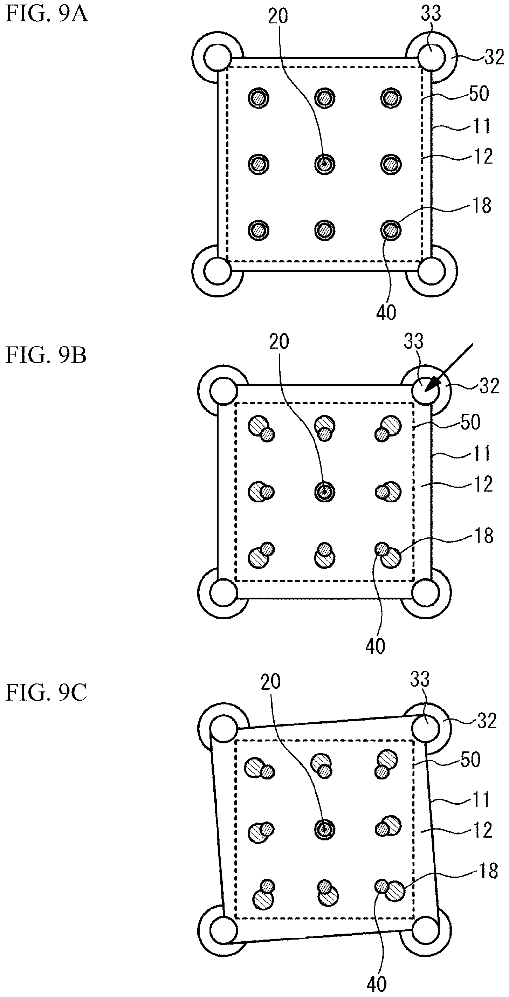

FIGs. 9A to 9C are plan views illustrating problems generated in the quantum device 500 according to the comparative example. In FIGs. 9A to 9C, the electrode 18 and the conductor pin 40 are illustrated through the substrate 11, but for the sake of clarity of the drawings, the electrode 18 and the conductor pin 40 are illustrated by solid lines, and a case where the electrode 18 is also provided at the center 20 of the substrate 11 is illustrated.

FIG. 9A illustrates a state in which the peripheral edge portion of the substrate 11 is mounted on the mounting surfaces 32 and the conductor pins 40 are brought into contact with the electrodes 18 under the normal temperature environment as described with reference to FIG. 6A. At the stage where the conductor pins 40 are brought into contact with the electrodes 18 in the normal temperature environment, the plurality of conductor pins 40 and the plurality of electrodes 18 are aligned with each other with high accuracy, and the plurality of conductor pins 40 are electrically well connected to the plurality of electrodes 18.

FIG. 9B illustrates a state in which the quantum device 500 is cooled to the low temperature as described with reference to FIG. 6B. When the quantum device 500 is cooled to the low temperature, the substrate 11, the mounting portion 30, and the holding portion 50 thermally contract according to the respective linear expansion coefficients. For example, when the substrate 11 is formed of silicon and the holding portion 50 is formed of aluminum, the holding portion 50 has a larger amount of thermal contraction than the substrate 11. Therefore, the holding portion 50 thermally contracts relative to the substrate 11 toward the center 20 of the substrate 11. Therefore, the conductor pin 40 held by the holding portion 50 moves relative to the substrate 11 toward the center 20 of the substrate 11. The amount of movement of the conductor pin 40 with respect to the substrate 11 is hardly present at the center 20 of the substrate 11, and increases as the conductor pin 40 is closer to the peripheral edge portion of the substrate 11. As a result, the conductor pin 40 may be misaligned with respect to the electrode 18, and an increase in electrical resistance between the conductor pin 40 and the electrode 18 or electrical disconnection between the conductor pin 40 and the electrode 18 may occur.

For example, in a case where the substrate 11 is formed of silicon, the holding portion 50 is formed of aluminum, and the substrate 11 is a square with one side of 20 mm, when the difference in temperature is 300 °C, the difference in the amount of thermal contraction at the corner of the substrate 11 is 0. 085 mm. When the length of one side of the substrate 11 is 40 mm, the difference in the amount of thermal contraction at the corner of the substrate 11 is 0. 170 mm. As described above, when the size of the substrate 11 is increased in order to increase the number of quantum bits 15, the difference in the amount of thermal contraction in the peripheral edge portion of the substrate 11 increases. Therefore, for example, when the radius of the electrode 18 is 0. 075 mm to 0. 15 mm, the conductor pin 40 may be displaced from the electrode 18 depending on the size of the substrate 11, and thus, the electrical connection failure may occur.

The peripheral edge portion of the substrate 11 is merely mounted on the mounting surfaces 32 and is not fixed. Therefore, as illustrated in FIG. 9C, the substrate 11 may rotate relative to the mounting portion 30 in the process of thermal contraction. Since the holding portion 50 is fixed to the mounting portion 30 and is suppressed from rotating relative to the mounting portion 30, when the substrate 11 rotates relative to the mounting portion 30, the positional misalignment between the conductor pin 40 and the electrode 18 may further increase.

### [Effects of First Embodiment]

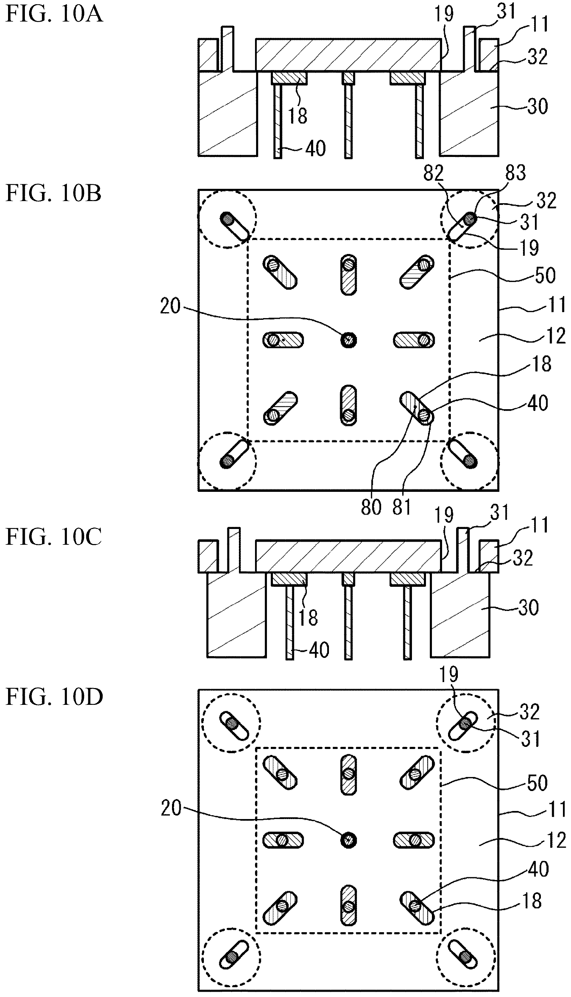

FIGs. 10A to 10D are diagrams illustrating the effect of the quantum device 100 in accordance with the first embodiment. FIGs. 10A and 10C are cross-sectional views, and FIGs. 10B and 10D are plan views. In FIGs. 10A to 10D, the case where the electrode 18 is also provided at the center 20 of the substrate 11 is illustrated as an example. In FIGs. 10B and 10D, the electrodes 18 and the conductor pins 40 are illustrated as if they were seen through the substrate 11, but are illustrated by solid lines for the sake of clarity of the drawings.

FIGs. 10A and 10B illustrates a state in which the peripheral edge portion of the substrate 11 is mounted on the mounting surfaces 32 and the conductor pins 40 are brought into contact with the electrodes 18 under the normal temperature environment as described with reference to FIG. 6A. In the normal temperature environment, the protrusion 31 provided on the mounting surface 32 is inserted into the hole 19 between the center 82 of the hole 19 provided in the substrate 11 and the end 83 of the hole 19 on the opposite side to the center 20 of the substrate 11 in plan view. In addition, in the normal temperature environment, each of the conductor pins 40 other than the conductor pin 40 located at the center 20 of the substrate 11 is in contact with the electrode 18 between the center 80 of the electrode 18 and the end 81 of the electrode 18 on the side opposite to the center 20 of the substrate 11 in plan view. The conductor pins 40 and the electrodes 18 are aligned with high accuracy, and the conductor pins 40 are electrically well connected to the electrodes 18.

FIGs. 10C and 10D illustrates a state in which the quantum device 100 is cooled to the low temperature as described with reference to FIG. 6B. In the case where the substrate 11 is a silicon substrate, the holding portion 50 is formed of aluminum, and the mounting portion 30 is formed of ceramics or glass, when the quantum device 100 is cooled, the holding portion 50 and the mounting portion 30 thermally contract by a larger contraction amount than the substrate 11. The electrode 18 with which the tip of the conductor pin 40 held by the holding portion 50 is in contact has the elongated shape having the longitudinal direction in the direction radially extending from the center 20 of the substrate 11. Therefore, even if the conductor pin 40 moves toward the center 20 of the substrate 11 with respect to the substrate 11 due to the thermal contraction of the holding portion 50, the contact between the conductor pin 40 and the electrode 18 is kept in a good condition. The substrate 11 is mounted on the mounting surfaces 32 by inserting the protrusions 31 of the mounting surfaces 32 into the holes 19 provided in the substrate 11. Therefore, the substrate 11 is suppressed from rotating with respect to the mounting portion 30. Since the holding portion 50 is fixed to the mounting portion 30 and is suppressed from rotating relative to the mounting portion 30, the substrate 11 is also suppressed from rotating relative to the holding portion 50. Since the hole 19 has the elongated shape having the longitudinal direction in the direction radially extending from the center 20 of the substrate 11, even if the substrate 11 and the mounting portion 30 have different linear expansion coefficients, the movement direction of the conductor pin 40 can be guided to the longitudinal direction of the electrode 18 without causing damage due to stress or the like. Therefore, the conductor pin 40 can be kept in good contact with the electrode 18, and the occurrence of the electrical connection failure between the conductor pin 40 and the electrode 18 can be suppressed.

According to the first embodiment, as illustrated in FIG. 1, the electrode 18 electrically connected to the quantum bit 15 provided on the upper surface 12 (first surface) is provided on the lower surface 13 (second surface) of the substrate 11. The tip of the conductor pin 40 held by the holding portion 50 is in contact with the electrode 18. The holding portion 50 is fixed to the mounting portion 30 having the mounting surface 32 on which the peripheral edge portion of the quantum chip 10 is mounted. The mounting surfaces 32 is provided with the protrusions 31. The quantum chip 10 is mounted on the mounting surfaces 32 by inserting the protrusions 31 provided on the mounting surface 32 into the holes 19 provided in the substrate 11. As illustrated in FIG. 2, the electrode 18 and the hole 19 have the elongated shape having the longitudinal direction in the direction radially extending from the center 20 of the substrate 11 in plan view. Accordingly, even when the linear expansion coefficient of the mounting portion 30 and the holding portion 50 is different from the linear expansion coefficient of the substrate 11, as described with reference to FIGs. 10A to 10D, the conductor pin 40 maintains good contact with the electrode 18 even when the temperature of the quantum device 100 changes. Therefore, it is possible to suppress the occurrence of the electrical connection failure between the conductor pin 40 and the electrode 18.

In addition, according to the first embodiment, as illustrated in FIGs. 4A to 5B, the quantum chip 10 in which the quantum bit 15 is provided on the upper surface 12 of the substrate 11 and the electrode 18 electrically connected to the quantum bit 15 is provided on the lower surface 13 is prepared. The electrode 18 has the elongated shape having the longitudinal direction in the direction radially extending from the center 20 of the substrate 11 in plan view. As illustrated in FIG. 5D, the mounting portion 30 having the mounting surface 32 on which the peripheral edge portion of the quantum chip 10 is mounted and the holding portion 50 that is fixed to the mounting portion 30 and holds the conductor pin 40 are prepared. The mounting portion 30 and the holding portion 50 have a linear expansion coefficient different from that of the substrate 11. As illustrated in FIG. 6A, the protrusions 31 are provided on the mounting surfaces 32, and the holes 19 are provided in the substrate 11. The hole 19 has the elongated shape having the longitudinal direction in the direction radially extending from the center 20 of the substrate 11 in plan view. In an environment of normal temperature (first temperature), the protrusion 31 is inserted into the hole 19, and thereby the peripheral edge portion of the quantum chip 10 is mounted on the mounting surface 32 so that the tip of the conductor pin 40 comes into contact with the electrode 18. As illustrated in FIG. 6B, after the quantum chip 10 is mounted on the mounting surface 32, the mounting portion 30 to which the quantum chip 10 and the holding portion 50 are fixed is cooled to the low temperature (second temperature lower than the first temperature). Accordingly, as described with reference to FIGs. 10A and 10B, even when the mounting portion 30 to which the quantum chip 10 and the holding portion 50 are fixed is cooled to the low temperature, it is possible to suppress the occurrence of the electrical connection failure between the conductor pin 40 and the electrode 18.

From the viewpoint of keeping the conductor pin 40 in contact with the electrode 18 even when the conductor pin 40 moves due to the thermal contraction of the holding portion 50, the length of the electrode 18 in the longitudinal direction is preferably 1.5 times or more, more preferably 2.0 times or more, and still more preferably 2.5 times or more the length thereof in the lateral direction. From the viewpoint of suppressing the occurrence of stress due to thermal contraction between the mounting portion 30 and the substrate 11, the length of the hole 19 in the longitudinal direction is preferably 1.5 times or more, more preferably 2.0 times or more, and still more preferably 2.5 times or more the length thereof in the lateral direction. From the viewpoint of suppressing the rotation of the substrate 11 with respect to the mounting portion 30 and the holding portion 50, the length of the hole 19 in the lateral direction is preferably equal to or less than 1.15 times, more preferably equal to or less than 1.10 times, and still more preferably equal to or less than 1.05 times the width of the protrusion 31.

In the first embodiment, the quantum bit 15 includes the Josephson junction element 21. The Josephson junction element 21 is used after being cooled to a temperature at which the lower electrode 25 and the upper electrode 27, which are superconducting films, exhibit superconductivity. That is, in FIG. 6B, the mounting portion 30 to which the quantum chip 10 and the holding portion 50 are fixed is cooled to the second temperature at which the lower electrode 25 and the upper electrode 27, which are the superconducting films of the Josephson junction element 21, exhibit superconductivity. As described above, even when the mounting portion 30 to which the quantum chip 10 and the holding portion 50 are fixed is cooled to the low temperature at which the mounting portion 30 becomes superconductive, the electrode 18 has the elongated shape, and the protrusion 31 of the mounting surface 32 is inserted into the elongated hole 19 of the substrate 11, so that the conductor pin 40 can be kept electrically well connected to the electrode 18.

In the first embodiment, the holes 19 are located at two or more corners of the substrate 11 having a rectangular shape in plan view. Since the holes 19 are located at two or more corners of the substrate 11, the substrate 11 can be suppressed from rotating with respect to the mounting portion 30, and thus the substrate 11 can be suppressed from rotating with respect to the holding portion 50 fixed to the mounting portion 30. Therefore, the conductor pin 40 can be kept electrically well connected to the electrode 18. From the viewpoint of suppressing the rotation of the substrate 11, the holes 19 are preferably located at least at two corner portions located diagonally of the substrate 11, and more preferably located at four corner portions.

In the first embodiment, the hole 19 is provided to penetrate the substrate 11, and the protrusion 31 is inserted into the hole 19 through the substrate 11. In this case, the holes 19 can be formed simultaneously with the holes 14 in which the via wirings 16 are formed, and thus the quantum chip 10 can be formed easily. In addition, since the protrusions 31 are inserted into the holes 19 penetrating the substrate 11, the quantum chip 10 is easily mounted on the mounting surface 32.

In the first embodiment, the substrate 11 is formed of silicon, the holding portion 50 is formed of aluminum, and the mounting portion 30 is formed of ceramics such as alumina or glass. Therefore, the mounting portion 30 and the holding portion 50 have a larger linear expansion coefficient than that of the substrate 11. Therefore, although the amount of thermal contraction of the mounting portion 30 and the holding portion 50 is larger than that of the substrate 11, the conductor pin 40 can be kept electrically well connected to the electrode 18 because the electrode 18 and the hole 19 have the elongated shape in plan view.

The substrate 11 is not limited to a silicon substrate, and may be formed using an insulating material such as a glass substrate, a quartz substrate, a sapphire substrate, an alumina substrate, or a silicon carbide substrate. The holding portion 50 is not limited to being formed of aluminum, and may be formed of another material as long as the material holds the conductor pin 40 and has a linear expansion coefficient different from that of the substrate 11. The mounting portion 30 is preferably formed of an insulating material, and when the linear expansion coefficient of the holding portion 50 is larger than the linear expansion coefficient of the substrate 11, the mounting portion 30 preferably has a linear expansion coefficient larger than that of the substrate 11, similarly to the holding portion 50. On the other hand, when the linear expansion coefficient of the holding portion 50 is smaller than the linear expansion coefficient of the substrate 11, the mounting portion 30 preferably has a smaller linear expansion coefficient than the substrate 11.

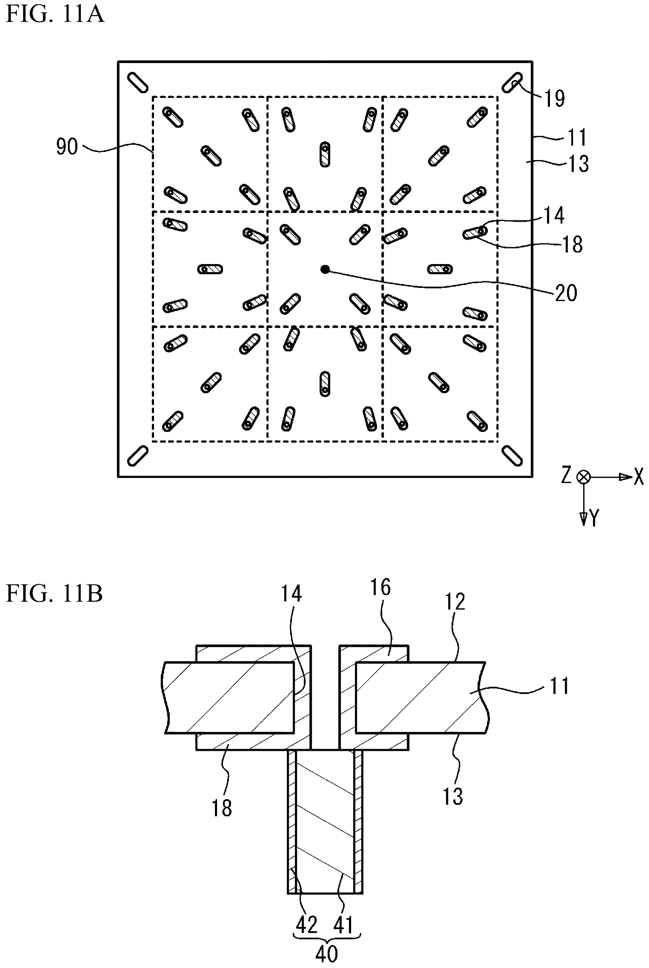

FIG. 11A is a plan view illustrating the substrate 11 in a case where the number of quantum bits 15 is increased in the first embodiment. FIG. 11A illustrates an example of a case where nine cells 90 in which four quantum bits 15 are formed are provided in a lattice shape. In this manner, the plurality of cells 90 in which the plurality of quantum bits 15 are formed may be provided on the substrate 11. When the number of quantum bits 15 is increased, the substrate 11 is increased in size, and thus a difference in thermal contraction amount between the substrate 11 and the holding portion 50 increases toward the peripheral edge portion of the substrate 11. Therefore, since the positional misalignment between the conductor pin 40 and the electrode 18 increases, it is preferable to use the electrode 18 and the hole 19 having the elongated shape having the longitudinal direction in the direction radially extending from the center 20 of the substrate 11 in plan view as in the first embodiment.

FIG. 11B is a cross-sectional view illustrating another example of the shape of the tip of the conductor pin 40 in the first embodiment. In the first embodiment, as illustrated in FIG. 1, the case where the tip of the conductor pin 40 has a shape rounded in an arc shape is illustrated as an example, but the present disclosure is not limited to this case, and other cases may be used. For example, as illustrated in FIG. 11B, the tip of the conductor pin 40 may have a flat shape. In either case, the frictional resistance between the tip of the conductor pin 40 and the electrode 18 is reduced, and thus the tip of the conductor pin 40 is likely to move while being in contact with the electrode 18.

### [Modification]

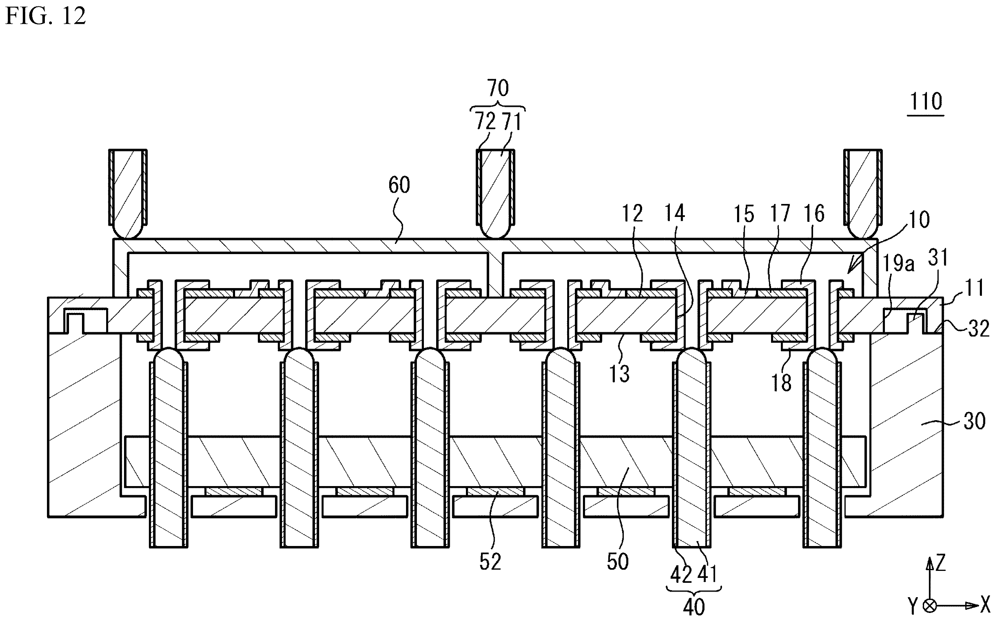

FIG. 12 is a cross-sectional view of a quantum device 110 in accordance with a modification of the first embodiment. As illustrated in FIG. 12, in the modification of the first embodiment, holes 19a provided in the substrate 11 does not penetrate the substrate 11, but are provided on the lower surface 13 of the substrate 11 as grooves. Therefore, the protrusions 31 inserted into the holes 19a do not penetrate the substrate 11. The depth of the hole 19a is, for example, 1/4 or more and 3/4 or less of the thickness of the substrate 11, and may be 1/3 or more and 2/3 or less of the thickness of the substrate 11. The other configurations are the same as those of the first embodiment, and thus the description thereof will be omitted. The quantum device 110 according to the modification of the first embodiment is formed by the same method as the manufacturing method of the quantum device 100 of the first embodiment illustrated in FIGs. 4A to FIG. 6B, except that the holes 19a that do not penetrate the substrate 11 is formed in FIG. 4B of the first embodiment.

Even when the holes 19a do not penetrate the substrate 11 as in the modification of the first embodiment, the occurrence of the electrical connection failure between the conductor pins 40 and the electrodes 18 can be suppressed as in the first embodiment.

### [Second Embodiment]

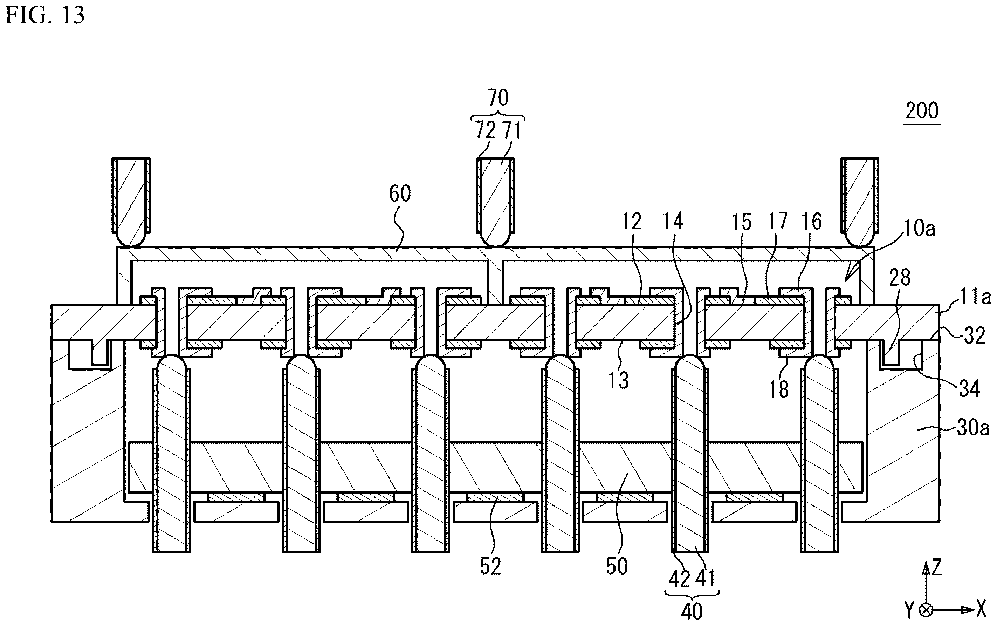

FIG. 13 is a cross-sectional view of a quantum device 200 in accordance with a second embodiment. As illustrated in FIG. 13, in the second embodiment, protrusions 28 are provided on the peripheral edge portion of the lower surface 13 of a substrate 11a, and holes 34 are provided in the mounting surface 32 of a mounting portion 30a. A quantum chip 10a is mounted on the mounting surfaces 32 by inserting the protrusions 28 provided on the substrate 11a into the holes 34 provided on the mounting surface 32. The other configurations of the second embodiment are the same as those of the first embodiment, and thus the description thereof will be omitted.

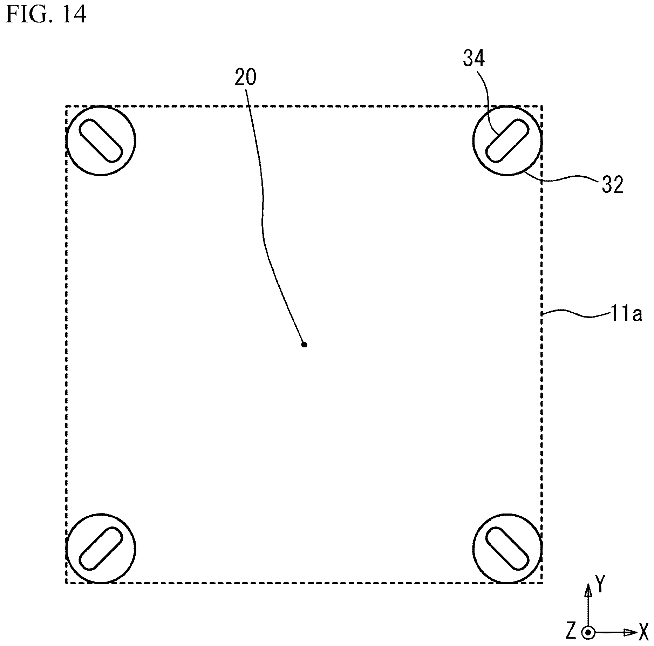

FIG. 14 is a plan view illustrating the mounting surface 32 in the second embodiment. In FIG. 14, the substrate 11a is also indicated by a dotted line. As illustrated in FIG. 14, the holes 34 provided on the mounting surface 32 have an elongated shape having a longitudinal direction in a direction radially extending from the center 20 of the substrate 11a in plan view, similarly to the holes 19 in the first embodiment illustrated in FIG. 2. The hole 34 has, for example, an oval shape in plan view, similarly to the hole 19, but may have an elliptical shape, a rectangular shape, or the like. The holes 34 are located at four corners of the substrate 11a, similarly to the holes 19.

### [Manufacturing Method]

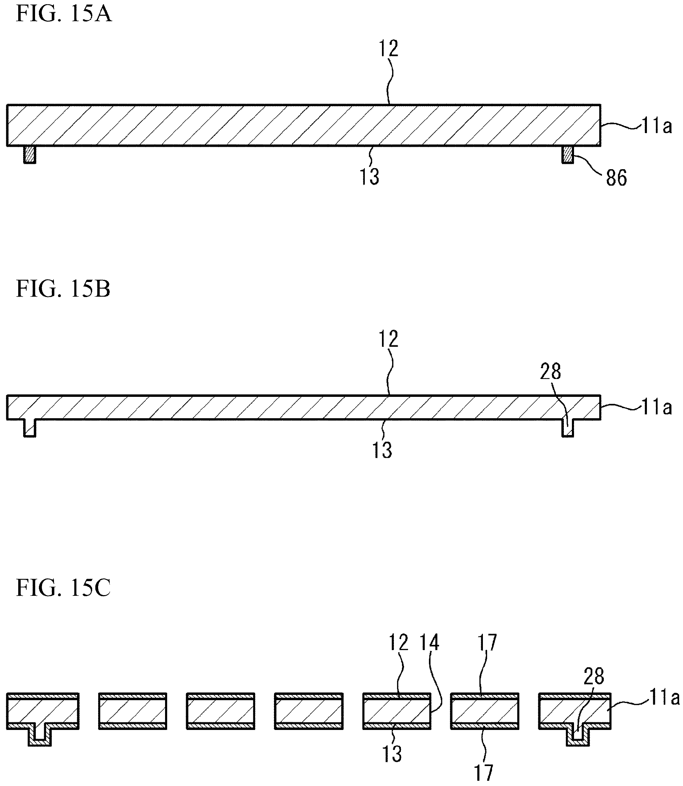

FIGs. 15A to 17B are cross-sectional views illustrating a method of manufacturing the quantum device 200 in accordance with the second embodiment. As illustrated in FIG. 15A, a resist pattern 86 is formed on the lower surface 13 of the substrate 11a, which is, for example, a silicon substrate, by using the photolithography method.

As illustrated in FIG. 15B, the lower surface 13 of the substrate 11a is etched using the resist pattern 86 as a mask. Thereafter, the resist pattern 86 is removed. As a result, the protrusions 28 are formed on the lower surface 13 of the substrate 11a. The height of the protrusion 28 is equal to or less than the depth of the hole 34 formed in the mounting surface 32. The lower surface 13 is etched by, for example, the reactive ion etching method.

As illustrated in FIG. 15C, the superconducting film 17 is formed on the upper surface 12 and the lower surface 13 of the substrate 11a. Thereafter, the superconducting film 17 and the substrate 11a are etched using a resist pattern (not illustrated) formed on the upper surface 12 and the lower surface 13 of the substrate 11a as a mask, thereby forming the hole 14 penetrating the substrate 11a from the upper surface 12 to the lower surface 13. Thereafter, the resist pattern is removed.

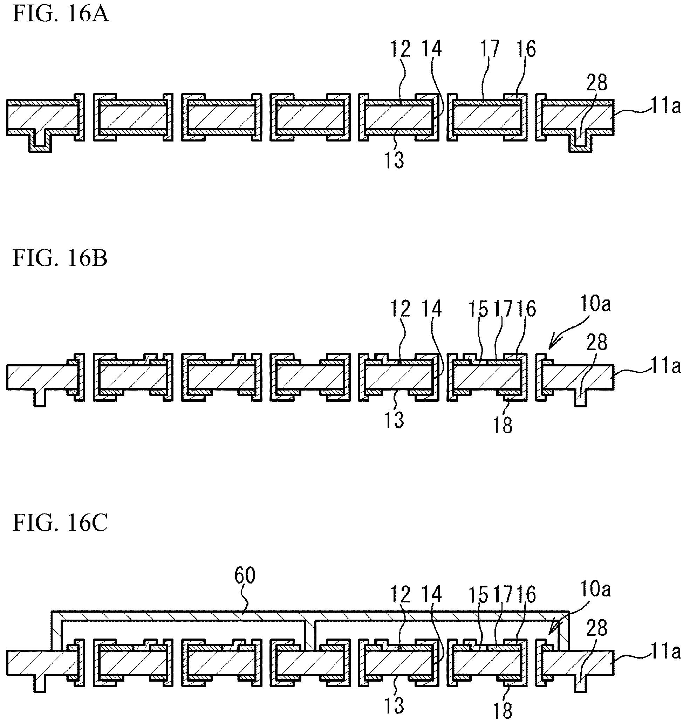

As illustrated in FIG. 16A, a superconducting film is formed on the upper surface 12 and the lower surface 13 of the substrate 11a. The superconducting film is also formed on the inner wall surface of the hole 14. Thereafter, the superconducting film is patterned by etching using resist patterns (not illustrated) formed on the upper surface 12 and the lower surface 13 of the substrate 11a as masks. As a result, the via wiring 16 is formed to extend from the upper surface 12 of the substrate 11a to the lower surface 13 through the hole 14. Thereafter, the resist patterns are removed.

As illustrated in FIG. 16B, the superconducting film 17 is patterned by etching using resist patterns (not illustrated) formed on the upper surface 12 and the lower surface 13 of the substrate 11a as masks. Thereafter, the resist patterns are removed. Next, the quantum bit 15 connected to the superconducting film 17 is formed on the upper surface 12 of the substrate 11a. Thus, the quantum chip 10a is formed.

As illustrated in FIG. 16C, the cover portion 60 is disposed on the upper surface 12 of the substrate 11a. The cover portion 60 is not bonded to the upper surface 12 of the substrate 11a.

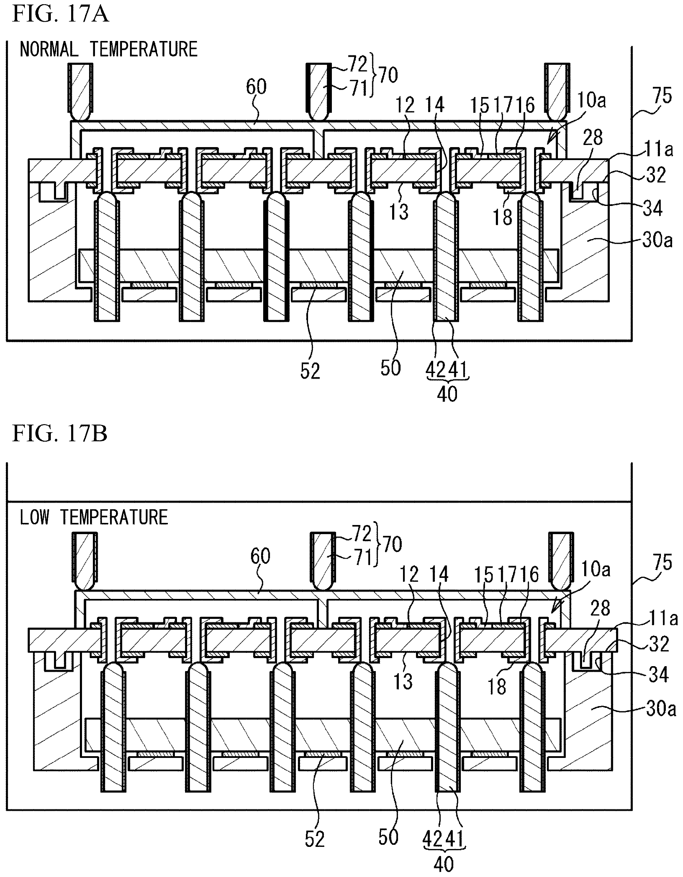

As illustrated in FIG. 17A, the mounting portion 30a having the mounting surface 32 and the hole 34 provided in the mounting surface 32, and the holding portion 50 fixed to the mounting portion 30a via the elastic body portion 52 and holding the conductor pin 40 are disposed in the refrigerator 75. The holes 34 are formed by, for example, etching the mounting surface 32. At this stage, the inside of the refrigerator 75 is not cooled and is at the normal temperature. Thereafter, the protrusions 28 of the substrate 11a are inserted into the holes 34 of the mounting surfaces 32, and the peripheral edge portion of the quantum chip 10a is mounted on the mounting surfaces 32. As a result, the tips of the conductor pins 40 comes into contact with the electrodes 18 provided on the lower surface 13 of the substrate 11a. The ground pin 70 is pressed against the upper surface of the cover portion 60, and the cover portion 60 is pressed against the substrate 11.

As illustrated in FIG. 17B, the inside of the refrigerator 75 is exhausted, and the temperature inside the refrigerator 75 is cooled to the low temperature at which the lower electrode 25 and the upper electrode 27 of the quantum bit 15 exhibit superconductivity. Thus, the quantum chip 10a operates in the superconducting state.

### [Effects of Second Embodiment]

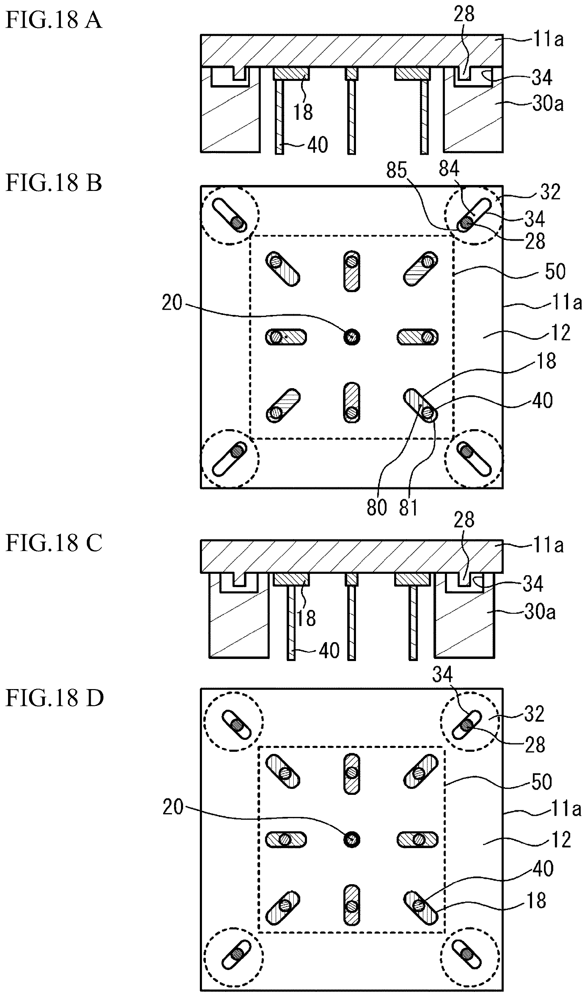

FIGs. 18A to 18D are diagrams illustrating the effect of the quantum device 200 in accordance with the second embodiment. FIGs. 18A and 18C are cross-sectional views, and FIGs. 18B and 18D are plan views. In FIGs. 18A to 18D, the electrodes 18 are also provided at the center 20 of the substrate 11a. In FIGs. 18B and 18D, the electrodes 18, the conductor pins 40, the holes 34, and the protrusions 28 are illustrated as if they were seen through the substrate 11a, but are illustrated by solid lines for the sake of clarity of the drawings.

FIGs. 18A and 18B illustrate a state where the peripheral edge portion of the substrate 11a is mounted on the mounting surface 32 and the conductor pins 40 are brought into contact with the electrodes 18 under the normal temperature environment as described with reference to FIG. 17A. Under the normal temperature environment, the protrusion 28 provided on the lower surface 13 of the substrate 11a is inserted into the hole 34 between a center 84 of the hole 34 provided on the mounting surface 32 and an end 85 of the hole 34 on the center 20 of the substrate 11 in plan view. In addition, under the normal temperature environment, each of the conductor pins 40 other than the conductor pin 40 located at the center 20 of the substrate 11 is in contact with the electrode 18 between the center 80 of the electrode 18 and the end 81 of the electrode 18 on the side opposite to the center 20 of the substrate 11 in plan view. The conductor pins 40 and the electrodes 18 are aligned with high accuracy, and the conductor pins 40 can be kept electrically well connected to the electrodes 18.

FIGs. 18C and 18D illustrate a state in which the quantum device 200 is cooled to the low temperature as described with reference to FIG. 17B. In the case where the substrate 11a portion is a silicon substrate, the holding portion 50 is formed of aluminum, and the mounting portion 30 is formed of ceramics such as alumina or glass, when the quantum device 200 is cooled, the holding portion 50 and the mounting portion 30 are thermally contracted by a larger amount than the substrate 11a. Each of the electrodes 18 with which the tips of the conductor pins 40 held by the holding portions 50 are in contact has the elongated shape having the longitudinal direction in the direction radially extending from the center 20 of the substrate 11a. Therefore, even if the conductor pins 40 move toward the center 20 of the substrate 11a with respect to the substrate 11a due to the thermal shrinkage of the holding portion 50, the contact between the conductor pins 40 and the electrodes 18 is kept in a good condition. The substrate 11a is mounted on the mounting surfaces 32 by inserting the protrusions 28 of the substrate 11a into the holes 34 of the mounting surface 32. Therefore, the substrate 11a is suppressed from rotating with respect to the mounting portion 30a. Since the holding portion 50 is fixed to the mounting portion 30a and is suppressed from rotating relative to the mounting portion 30a, the substrate 11a is also suppressed from rotating relative to the holding portion 50. Since each of the holes 34 has the elongated shape having the longitudinal direction in the direction radially extending from the center 20 of the substrate 11a, even if the substrate 11a and the mounting portion 30a have different linear expansion coefficients, the movement direction of the conductor pins 40 can be guided in the longitudinal direction of the electrodes 18 without causing damage due to stresses or the like. Therefore, the conductor pins 40 can be kept in good contact with the electrodes 18, and the occurrence of the electrical connection failure between the conductor pins 40 and the electrodes 18 can be suppressed.

According to the second embodiment, as illustrated in FIG. 13, the quantum chip 10a is mounted on the mounting surfaces 32 by inserting the protrusions 28 provided on the substrate 11a into the holes 34 provided on the mounting surfaces 32 of the mounting portion 30a. The holding portion 50 for holding the conductor pins 40 is fixed to the mounting portion 30a. As illustrated in FIG. 2, each of the electrodes 18 has the elongated shape having the longitudinal direction in the direction radially extending from the center 20 of the substrate 11a in plan view. As illustrated in FIG. 14, each of the holes 34 has the elongated shape having the longitudinal direction in the direction radially extending from the center 20 of the substrate 11a in plan view. Thus, even when the linear expansion coefficients of the mounting portion 30 and the holding portion 50 are different from the linear expansion coefficient of the substrate 11a, the conductor pins 40 are kept in good contact with the electrodes 18 even when the temperature of the quantum device 200 changes, as described with reference to FIGs. 18A to 18D. Therefore, it is possible to suppress the occurrence of the electrical connection failure between the conductor pin 40 and the electrode 18.

In addition, according to the second embodiment, as illustrated in FIGs. 15A to 16B, the quantum chip 10a in which the quantum bit 15 is provided on the upper surface 12 of the substrate 11a and the electrodes 18 electrically connected to the quantum bit 15 are provided on the lower surface 13 is prepared. Each of the electrodes 18 has the elongated shape having the longitudinal direction in the direction radially extending from the center 20 of the substrate 11a in plan view. As illustrated in FIG. 17A, the mounting portion 30a having the mounting surface 32 on which the peripheral edge portion of the quantum chip 10a is mounted, and the holding portion 50 fixed to the mounting portion 30a and holding the conductor pins 40 are prepared. The mounting portion 30a and the holding portion 50 have linear expansion coefficients different from that of the substrate 11a. The holes 34 are provided on the mounting surfaces 32, and the protrusions 28 are provided on the substrate 11a. Each of the holes 34 has the elongated shape having the longitudinal direction in the direction radially extending from the center 20 of the substrate 11a in plan view. The protrusions 28 are inserted into the holes 34 under the normal temperature (first temperature), and the peripheral edge portion of the quantum chip 10a is mounted on the mounting surfaces 32 so that the tips of the conductor pins 40 contact the electrodes 18. As illustrated in FIG. 17B, after the quantum chip 10a is mounted on the mounting surfaces 32, the mounting portion 30 to which the quantum chip 10a and the holding portion 50 are fixed is cooled to the low temperature (second temperature lower than the first temperature). Accordingly, as described with reference to FIGs. 18A and 18B, even when the mounting portion 30 to which the quantum chip 10a and the holding portion 50 are fixed is cooled to the low temperature, it is possible to suppress the occurrence of the electrical connection failure between the conductor pins 40 and the electrodes 18.

Although the embodiment of the present invention is described in detail, the present invention is not limited to the specifically described embodiments and variations but other embodiments and variations may be made without departing from the scope of the claimed invention.

## Claims

1. A quantum device (100, 110, 200) comprising:
a quantum chip (10, 10a) including a substrate (11, 11 a) having a first surface (12) and a second surface (13), a quantum bit (15) provided on the first surface, and an electrode (18) electrically connected to the quantum bit and provided on the second surface;
a mounting portion (30) having a mounting surface (32) on which a peripheral edge portion of the quantum chip is mounted, the mounting portion having a linear expansion coefficient different from that of the substrate;
a conductor pin (40) having a tip end in contact with the electrode; and
a holding portion (50) fixed to the mounting portion, the holding portion holding the conductor pin and having a linear expansion coefficient different from that of the substrate;
wherein the electrode has a shape having a longitudinal direction in a direction radially extending from a center (20) of the substrate in plan view, and
the quantum chip is mounted on the mounting surface by inserting a protrusion (31) provided on one of the substrate and the mounting surface into a hole (19) provided on another of the substrate and the mounting surface, the hole having a longitudinal direction in a direction extending radially in plan view.

2. The quantum device according to claim 1,
wherein the quantum bit includes a Josephson junction element (21).

3. The quantum device according to claim 1 or 2,
wherein the substrate having a rectangular shape includes a plurality of holes (19), and the plurality of holes are located at two or more corners of the substrate in plan view.

4. The quantum device according to claim 1 or 2,
wherein the hole is provided in the substrate, and the protrusion is provided on the mounting surface.

5. The quantum device according to claim 4,
wherein the hole is provided to penetrate the substrate, and the protrusion is inserted into the hole by penetrating the substrate.

6. The quantum device according to claim 1 or 2,
wherein the hole is provided in the mounting surface, and the protrusion is provided in the substrate.

7. The quantum device according to any of the preceding claims, wherein the tip of the conductor pin is flat.

8. The quantum device according to any of the preceding claims,
wherein the mounting portion and the holding portion have a linear expansion coefficient larger than that of the substrate.

9. The quantum device according to claim 8,
wherein the substrate is a silicon substrate, the mounting portion is formed of ceramics or glass, and the holding portion is formed of aluminum.

10. A method of manufacturing a quantum device comprising:
preparing a quantum chip (10, 10a) including a substrate (11, 11a) having a first surface (12) and a second surface (13), a quantum bit (15) provided on the first surface, and an electrode (18) electrically connected to the quantum bit and provided on the second surface, the electrode having a longitudinal direction in a direction extending radially from a center (20) of the substrate in a plan view;
preparing a mounting portion (30) having a mounting surface (32) on which a peripheral edge portion of the quantum chip is mounted, the mounting portion having a linear expansion coefficient different from that of the substrate, and a holding portion (50) fixed to the mounting portion, the holding portion holding a conductor pin (40) and having a linear expansion coefficient different from that of the substrate;
mounting the peripheral edge portion of the quantum chip on the mounting surface so that a tip of the conductor pin is in contact with the electrode by inserting a protrusion (28, 31) provided on one of the substrate and the mounting surface into a hole (19, 34) provided on another of the substrate and the mounting surface at a first temperature, the hole having a longitudinal direction in a direction extending radially in plan view; and
cooling the mounting portion to which the quantum chip and the holding portion are fixed to a second temperature lower than the first temperature after the mounting.

11. The method of manufacturing the quantum device according to claim 10,
wherein the quantum bit includes a Josephson junction element (21), and the second temperature is a temperature at which a superconducting film of the Josephson junction element exhibits superconductivity.

12. The method of manufacturing the quantum device according to claim 11, wherein the first temperature is a normal temperature.

13. The method of manufacturing the quantum device according to any of claims 10-12,
wherein the substrate having a rectangular shape includes a plurality of holes (19), and the plurality of holes are located at two or more corners of the substrate in plan view.

14. The method of manufacturing the quantum device according to any of claims 10-12,
wherein the mounting includes mounting the peripheral edge portion of the quantum chip on the mounting surface by inserting the protrusion provided on the mounting surface into the hole provided in the substrate.

15. The method of manufacturing the quantum device according to any of claims 10-12,
wherein the mounting includes mounting the peripheral edge portion of the quantum chip on the mounting surface by inserting the protrusion provided on the substrate into the hole provided in the mounting surface.
